# EUROPÄISCHE PATENTSCHRIFT

(11) **EP 0 579 859 B1**
(45) Veröffentlichungstag und Bekanntmachung des Hinweises auf die Patenterteilung: **28.02.1996**
(21) Anmeldenummer: 92112707.2
(22) Anmeldetag: 24.07.1992
(51) Int. Cl.: H05K 7/14

(54) **Flachbaugruppe mit Führungsstiften zum positionsgenauen Einschub in einen Baugruppenträger**
Circuit board with guide pins for correct insertion in rack
Plaque de circuit imprimé avec des tiges de guidage pour l'insérer en position correcte dans un rack électronique

(43) Veröffentlichungstag der Anmeldung: 26.01.1994
(73) Patentinhaber: SIEMENS AKTIENGESELLSCHAFT, D-80333 München (DE)
(72) Erfinder: Behrens, Ralf, Dipl.-Ing. (FH), W-8500 Nürnberg (DE); Meier, Norbert, Dipl.-Ing. (FH), W-8439 Postbauer-Heng (DE); Schaffer, Kurt-Michael, W-8501 Eckental (DE)

(56) Entgegenhaltungen:
- WO-A-92/07453
- DE-A- 2 416 107
- DE-U- 7 204 444
- US-A- 4 994 937

## Beschreibung

Die Erfindung betrifft eine Flachbaugruppe mit Leiterplatte zum Einschub in einen Baugruppenträger, welcher zumindest eine untere und eine obere Längsführungsschiene mit jeweils einer Führungsnut für die Längskanten der Leiterplatte beim Einschub bzw. Auszug der Flachbaugruppe in den bzw. aus dem Baugruppenträger aufweist (siehe z.B. DE-A-2 416 107).

Flachbaugruppen, deren Leiterplatten z.B. hochkomplexe elektrische Schaltungen mit einer Vielzahl von integrierten Schaltkreisen bzw. z.B. oberflächenmontierbaren Bauelementen tragen, werden in der Regel senkrecht stehend und unmittelbar nebeneinander liegend in speziell zur Aufnahme von elektrischen Flachbaugruppen konzipierten Baugruppenträgern angeordnet. Dabei sind im Inneren des Baugruppenträgers für jede aufzunehmende Flachbaugruppe zumindest eine untere und eine obere Längsführungsschiene mit jeweils einer innen liegenden Führungsnut vorgesehen. Die Längskanten der zu einer senkrecht stehenden Flachbaugruppe gehörigen Leiterplatte werden in den Führungsnuten der dazugehörigen oberen und unteren Längsführungsschiene geführt. Die aktuelle Position der beiden Längsführungsschienen bestimmt die Lage der dazugehörigen Flachbaugruppe im Inneren des Baugruppenträgers, d.h. deren Einbauplatz. Eine elektrische Flachbaugruppe kann somit problemlos in den jeweils vorgesehenen Einbauplatz eingeschoben bzw. bei Bedarf wieder herausgezogen werden, da die Längskanten der Leiterplatte der Flachbaugruppe reibungsarm im Inneren der Führungsnuten der dazugehörigen unteren und oberen Längsführungsschiene gleiten können.

Zum Aufbau von elektrischen Systemen unterschiedlichster Art werden Baugruppenträger in vielen Fällen nahezu vollständig mit Flachbaugruppen bestückt. Diese befinden sich dann senkrecht stehend und unmittelbar nebeneinander liegend im Inneren des Baugruppenträgers. Je dichter die Packung der Flachbaugruppen ist, um so genauer muß jede Flachbaugruppe den durch die jeweilige Position der dazugehörigen unteren und oberen Längsführungsschiene zugewiesenen Einbauplatz einnehmen. Dennoch ist insbesondere für ein reibungsarmes Gleiten der Längskanten der Leiterplatte einer Flachbaugruppe im Inneren der Führungsnuten der Längsführungsschienen ein gewisses Spiel unumgänglich. Die Führungsnuten müssen somit eine Breite aufweisen, welche die Dicke der einzuführenden Leiterplatte nicht nur überschreitet, sondern den Längskanten der Leiterplatten einen gewissen Freiraum ermöglichen.

Hierdurch bedingt können sich insbesondere beim Einschieben einer Flachbaugruppe in einen Baugruppenträger dann Probleme ergeben, wenn die unmittelbar benachbarten Einbauplätze bereits mit Flachbaugruppen belegt sind. Dabei müssen Berührungen der einzuschiebenden Flachbaugruppe mit den rechts und links davon im Baugruppenträger befindlichen Flachbaugruppen vermieden werden. Solche können z.B. dann auftreten, wenn jede der Flachbaugruppen am frontseitigen Ende, d.h. an der vorderen Außenseite des Baugruppenträgers, über ein flächenartiges Abdeckelement verfügt, z.B. eine Frontplatte bzw. einen Frontsteckverbinder. Derartige Frontelemente nehmen nahezu den vollständigen Querschnitt des für die jeweilige Flachbaugruppe zur Verfügung stehenden Einbauplatzes ein. Bei einem lückenlos mit Flachbaugruppen bestückten Baugruppenträger liegen somit die Front platten der Flachbaugruppen in einer Ebene unmittelbar nebeneinander und bilden eine nahezu geschlossene Außenfläche. Wird nun eine der Flachbaugruppen einer derartigen Packung aus dem Baugruppenträger gezogen und anschließend wieder eingeschoben, so muß die Flachbaugruppe insbesondere kurz vor Erreichen des vollkommen eingesteckten Zustandes die vorgesehene Position im zugeordneten Einbauplatz möglichst gut einnehmen. Andernfalls besteht die Gefahr, daß die Frontplatte der einzuschiebenden Flachbaugruppe mit einer Längskante auf die Oberfläche der Frontplatte von einer der beiden rechts bzw. links bereits eingeschobenen Flachbaugruppen aufschlägt. Das vollständige Einschieben der Flachbaugruppe wäre in einem solchen Fall nur unter Aufwendung von zusätzlichen Seitenkräften möglich, um deren Position in Querrichtung zu korrigieren.

Derartige Probleme beim Einschieben einer Flachbaugruppe in den Baugruppenträger treten in noch stärkerem Maße dann auf, wenn die in einem Baugruppenträger zusammengefaßten Flachbaugruppen am frontseitigen Ende der jeweiligen Leiterplatte über zusätzliche Konstruktionselemente verfügen. Als ein Beispiel hierfür seien Kontaktfedern genannt. Ist ein Baugruppenträger z.B. elektromagnetisch abschirmend ausgeführt, so sind die Frontplatten der einzuschiebenden Flachbaugruppen aus elektrisch leitendem Metall gefertigt und weisen z.B. an einer Seitenkante über der gesamten Höhe eine Kontaktfeder auf. Nach dem vollständigen Einschieben einer derartigen Flachbaugruppe in den vorgesehenen Einbauplatz wird somit die dazugehörige Frontplatte mit den Frontplatten der benachbarten Flachbaugruppe elektrisch leitend kontaktiert und die senkrechten Schlitze zwischen den Frontplatten vollständig gegen den Eintritt bzw. Austritt von elektromagentischer Störstrahlung abgedichtet. Um bei einer derartigen Ausführung insbesondere das Ein schieben einer Flachbaugruppe in den vollständig eingesteckten Zustand ohne die Aufwendung von übermäßigem Kraftaufwand zu gewährleisten, muß sichergestellt sein, daß jede der Flachbaugruppen sich zumindest am frontseitigen Ende des Baugruppenträgers und zumindest unmittelbar vor Erreichung des vollständig eingesteckten Zustandes möglichst in der vorgesehenen Position im jeweiligen Einbauplatz befindet.

Dies ist z.B. auch dann notwendig, wenn die Flachbaugruppen am frontseitigen Ende im Bereich der Frontplatte bzw. eines Frontsteckverbinders Kodiermittel aufweisen. Diese sollen sicherstellen, daß eine Flachbaugruppe nur an dem zugelassenen Einbauplatz unter Herbeiführung von allen vorgesehenen elektrischen Kontaktierungen vollständig in den Baugruppenträger einschiebbar ist. Um eine ordnungsgemäße Funktion derartiger Kodiermittel zu gewährleisten und insbesondere unerwünschte Fehlblockierungen derselben zu verhindern, ist es auch in einem solchen Fall notwendig, daß die Flachbaugruppe zumindest gegen Ende des Einschubvorganges die vorgesehene Position im Einbauplatz möglichst genau einnimmt. Anderenfalls könnten die Kodiermittel unzulässig blockieren und das vollständige Einstecken verhindern, obwohl sich die Flachbaugruppe im richtigen, für sie vorgesehenen Einbauplatz befindet, bzw. es könnten auch Beschädigungen z.B. an den Kodiermitteln auftreten.

Der Erfindung liegt die Aufgabe zugrunde, eine Flachbaugruppe mit Leiterplatte derart weiter auszugestalten, daß diese beim Einschieben in einen Baugruppenträger zumindest kurz vor Erreichen des vollständig eingeschobenen Zustandes am frontseitigen Ende annähernd in der Idealposition geführt wird, und somit ein Verkanten bzw. ein Versatz derselben in Querrichtung vermieden wird.

Die Aufgabe wird gelöst mit den kennzeichnenden Merkmalen von Anspruch 1. Weitere, vorteilhafte Ausführungsformen derselben sind in den Unteransprüchen enthalten. Die Erfindung und vorteilhafte Ausführungsformen derselben werden anhand der nachfolgend kurz angeführten Figuren näher erläutert. Dabei zeigt
- FIG 1: eine erste vorteilhafte Ausführungsform der erfindungsgemäßen Vorrichtung am Beispiel eines Ausschnittes der unteren, frontseitigen Ecke einer Flachbaugruppe, welche zusätzlich über Einsteckkodiermittel verfügt,
- FIG 2: einen Ausschnitt aus dem unteren Schienensystem eines Baugruppenträgers zur Aufnahme der Flachbaugruppe von FIG 1, welches über Komplementärkodiermittel verfügt,
- FIG 3: eine zweite vorteilhafte Ausführungsform der Erfindung, wobei in Ergänzung zur Ausführung von FIG 1 zusätzliche voreilende Massekontaktmittel vorhanden sind,
- FIG 4: einen Ausschnitt aus dem unteren Schienensystem eines Baugruppenträgers zur Aufnahme der Flachbaugruppe von FIG 3, und
- FIG 5: eine dritte vorteilhafte Ausführungsform, wobei die erfindungsgemäße Flachbaugruppe zusätzlich über einen Frontsteckverbinder verfügt.

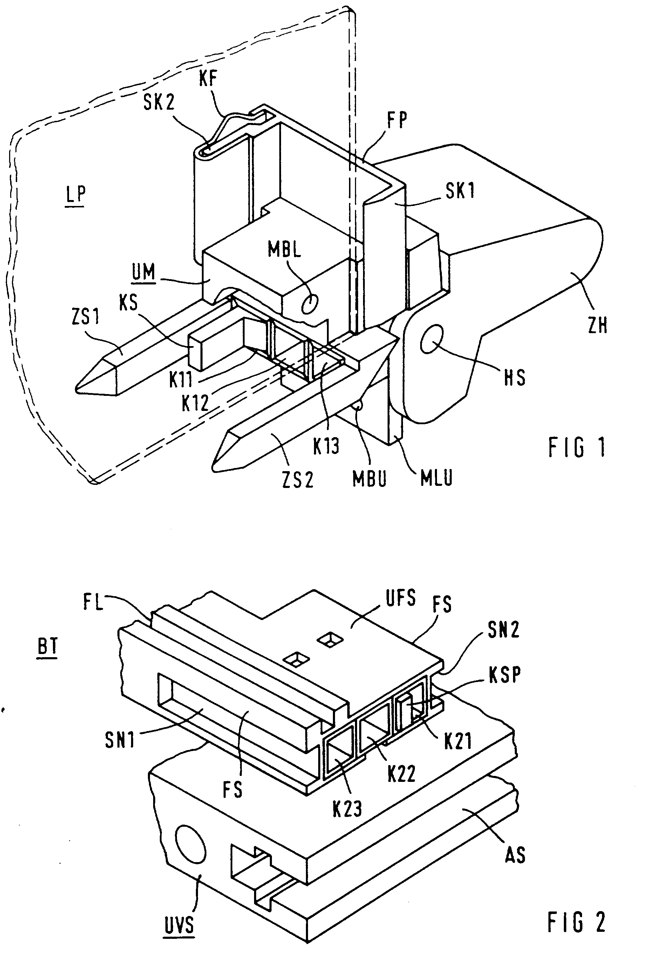

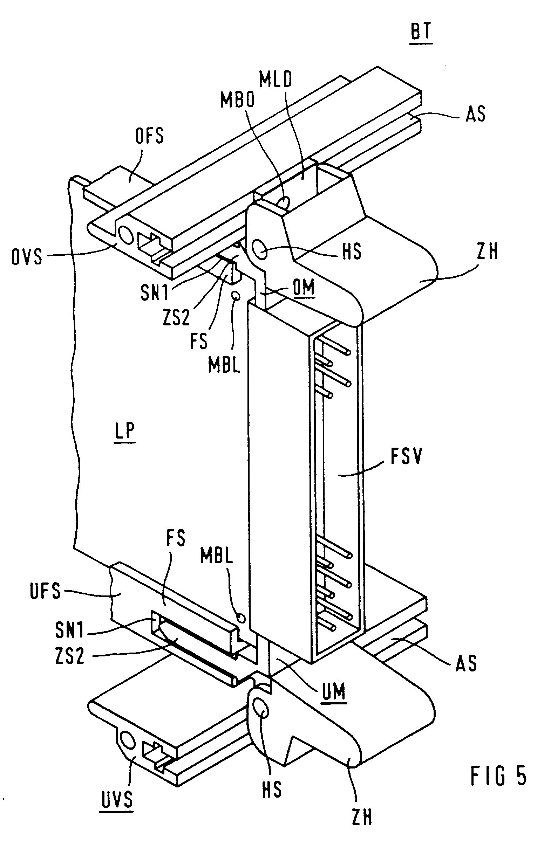

Die erfindungsgemäße Flachbaugruppe weist eine Leiterplatte LP auf, von der in FIG 1 die untere, frontseitige Ecke ausschnittsweise strichliert dargestellt ist. Die Flachbaugruppe ist zum Einschub in einen Baugruppenträger BT vorgesehen, von dem eine mögliche Ausführung eines unteren Schienensystems in der dazugehörigen FIG 2 ausschnittsweise dargestellt ist. Zum Einschub der Flachbaugruppe in den Baugruppenträger BT weist dieser zumindest eine untere und eine obere Längsführungsschiene mit jeweils einer Führungsnut auf. In diese greifen die Längskanten der Leiterplatte beim Einschub bzw. Auszug der Flachbaugruppe in den bzw. aus dem Baugruppenträger ein. Das Beispiel der FIG 2 zeigt eine untere Längsführungsschiene UFS mit einer Führungsnut FL, in welche die in FIG 1 strichliert dargestellte untere Längskante der Leiterplatte LP beim Einschub bzw. Auszug angreift. Ferner ist ein der FIG 2 entsprechendes, oberes Schienensystem vorhanden, welches aber aus Gründen der Übersichtlichkeit nicht dargestellt ist. Dieses weist zumindest eine obere Längsführungsschiene OFS mit ebenfalls einer Führungsnut FL auf, in welche die in FIG 1 nicht mehr dargestellte obere Längskante der Leiterplatte LP beim Einschub bzw. Auszug eingreift. Eine derartig vollständige Anordnung ist im Beipiel der FIG 5 dargestellt.

Erfindungsgemäß verfügt die Flachbaugruppe über mindestens einen Eckmontagekörper, welcher an einer der beiden frontseitigen Ecken der Leiterplatte befestigt ist und an den beiden Außenseiten je einen Führungsstift aufweist. Die Führungsstifte sind annähernd parallel zu den Längskanten der Leiterplatte angeordnet, in Einschubrichtung der Leiterplatte auf den Baugruppenträger gerichtet hervor stehend und stützen sich beim Einschieben der Flachbaugruppe auf den Seitenflanken der jeweils gegenüberliegenden Längsführungsschiene des Baugruppenträgers ab.

FIG 1 zeigt beispielhaft einen derartigen unteren Eckmontagekörper UM, welcher an der unteren, frontseitigen Ecke der Leiterplatte LP befestigt ist. Zur Verbindung von Leiterplatte LP und Eckmontagekörper UM dient beispielhaft eine seitliche Montagebohrung MBL, in die eine Schraube eingedreht werden kann. Erfindungsgemäß sind an den beiden Außenseiten des Eckmontagekörpers UM Führungsstifte ZS1, ZS2 vorgesehen. Diese sind annähernd parallel zur strichliert dargestellten, unteren Längskante der Leiterplatte LP angeordnet und stehen in Einschubrichtung der Leiterplatte auf den Baugruppenträger BT gerichtet hervor. Beim Einschieben der Flachbaugruppe stützen sich die Führungsstifte ZS1, ZS2 auf den Seitenflanken FS der in FIG 2 dargestellten, gegenüberliegenden unteren Längsführungsschiene UFS des Baugruppenträgers BT ab. Beim Einschub umfassen somit die Führungsstifte ZS1, ZS2 kurz vor Erreichen des vollständig eingeschobenen Zustandes die dazugehörige Längsführungsschiene, so daß die Flachbaugruppe in Längsrichtung, d.h. in Einschubrichtung, optimal geführt wird und in dieser Phase des Einschubvorganges kein Versatz in Querrichtung mehr auftreten kann. Hierdurch wird eine voreilende, positionsgenaue Zentrierung erreicht.

Gemäß der Darstellung von FIG 1 kann der Eckmontagekörper UM zusätzlich zur Halterung weiterer Teile der Flachbaugruppe dienen. So ist beispielsweise ein Ziehhebel ZH vorhanden, welcher mittels eines querverlaufenden Haltestiftes HS im Inneren des Eckmontagekörpers UM gelagert ist. Desweiteren kann der Eckmontagekörper UM zur Halterung einer Frontplatte FP dienen, von der im Beispiel der FIG 1 wiederum nur das untere Ende ausschnittsweise dargestellt ist. Die Frontplatte FP hat einen U-förmigen Querschnitt und weist somit die Seitenkanten SK1 und SK2 auf.

Im Beispiel der FIG 1 ist die Seitenkante SK2 mit einer über die gesamte Höhe der Frontplatte FP verlaufenden Kontaktfeder KF belegt. Bei metallischer Ausführung der Frontplatte FP wird hiermit eine elektrische Kontaktierung der Frontplatten benachbarter Flachbaugruppen und somit eine elektromagnetische Abschirmung des frontseitigen Bereiches von in den Baugruppenträger BT eingeschobenen Flachbaugruppen erreicht. Gerade bei einer solchen Ausführung kommt der Führung der Flachbaugruppe insbesondere beim Einschub in den Baugruppenträger besondere Bedeutung zu. Aufgrund der Länge der erfindungsgemäßen Führungsstifte ZS1, ZS2 am Eckmontagekörper UM umfassen diese rechtzeitig vor dem Ende des Einschubvorganges die gegenüberliegende untere Längsführungsschiene UFS. Greift nun beim weiteren Einschieben der Flachbaugruppe die Kontaktfeder KF auf die nicht dargestellte, rechte Seitenkante SK1 der Frontplatte einer bereits eingesteckten, links befindlichen Flachbaugruppe ein, so werden beim Verquetschen der Kontaktfeder KF die auf den Frontbereich der Flachbaugruppe in FIG 1 ausgeübten Querkräfte über den Eckmontagekörper UM und die Führungsstifte ZS1, ZS2 von der unteren Längsführungsschiene UFS und damit vom Baugruppenträger BT aufgenommen. Die Flachbaugruppe wird somit rechtzeitig vor Erreichen des vollständig eingeschobenen Zustandes sicher geführt und kann auch aufgrund der Einwirkung der Kontaktfeder KF seitlich nicht in Querrichtung ausweichen.

Die erfindungsgemäße, sichere Führung der Flachbaugruppe, insbesondere beim Einschieben in den Baugruppenträger in Längsrichtung ist auch besonders dann von Vorteil, wenn am frontseitigen Ende der Flachbaugruppe Kodiermittel vorhanden sind. In den Figuren 1,2 sind derartige Kodiermittel bereits beispielhaft dargestellt. So weist der Eckmontagekörper UM in FIG 1 Einsteckkodiermittel K11,K12, K13,KS auf, welche besonders vorteilhaft im Bereich zwischen den beiden Führungsstiften ZS1,ZS2 angeordnet sind. Die Einsteckkodiermittel werden somit von den Führungsstiften umfaßt. Beim Einstecken der Flachbaugruppe in den Baugruppenträger BT greifen die Einsteckkodiermittel in Komplementärkodiermittel K21,K22,K23,KSP ein, welche sich vorteilhaft am gegenüberliegenden, frontseitigen Ende der dazugehörigen unteren Längsführungsschiene UFS befinden bzw. dort integriert sind.

Eine derartige Anordnung hat den besonderen Vorteil, daß beim Einschubvorgang der Flachbaugruppe in den Baugruppenträger zuerst ein Abstützen der Führungsstifte ZS1,ZS2 auf den Seitenflanken FS der Längsführungsschiene UFS bewirkt wird, bevor beim weiteren Ablauf des Einschubvorganges die Einsteckkodiermittel auf der Innenseite des Eckmontagekörpers UM mit den gegenüberliegenden Komplementärkodiermittel am frontseitigen Ende der Längsführungsschiene UFS in Eingriff kommen. Auch hier bewirkt die erfindungsgemäße Abstützung der Führungsstifte an den Seitenflanken der dazugehörigen Längsführungsschiene eine rechtzeitige Führung der Flachbaugruppe, so daß im Moment des Eingriffes der Einsteck- mit den Komplementärkodiermitteln ein Versatz der Flachbaugruppe in Querrichtung mit Sicherheit ausgeschlossen ist. Hiermit kann ein störungsfreier Betrieb der Kodiermittel gewährleistet und insbesondere verhindert werden, daß z.B. aufgrund einer versehentlichen, z.B. von einer Kontaktfeder KF hervorgerufenen Querverschiebung die Kodiermittel versehentlich nicht ineinander eingreifen, obwohl diese bei Nichtauftreten der Querverschiebung problemlos ineinander eingreifen würden.

Bei der in FIG 1 und 2 dargestellten Ausführungsform weisen die Einsteck- und Komplementärkodiermittel vorteilhaft jeweils gegenüberliegende Kammern mit bevorzugt quadratischem Querschnitt auf. So sind in FIG 1 auf der Innenseite des Eckmontagekörpers UM in Einschubrichtung der Flachbaugruppe drei Kodierkammern K11,K12,K13 unmittelbar zwischen den beiden Führungsstiften ZS1,ZS2 angeordnet. Dementsprechend weist gemäß FIG 2 das frontseitige Ende der dazugehörigen Längsführungsschiene UFS des Baugruppenträgers BT ebenfalls drei nebeneinanderliegende Komplementärkammern K21,K22,K23 mit ebenfalls quadratischem Querschnitt auf. Aufgrund der erfindungsgemäßen Abstützung durch die Führungsstifte ZS1,ZS2 an den Seitenflanken FS der Längsführungsschiene UFS gegen Ende eines Einschubvorganges kommen die Kodierkammern K11,K12,K13 des Eckmontagekörpers UM unmittelbar gegenüber den Komplementärkammern K21,K22,K23 im frontseitigen Ende der Längsführungsschiene zu liegen. In die Kammern eingesteckte Kodiermittel können somit fehlerfrei ineinander eingreifen.

Im Beispiel der Figuren 1,2 ist die Kodierkammer K11 und die dazugehörige Komplementärkammer K21 bereits mit derartigen Kodiermitteln versehen. So ist in die Kodierkammer K11 ein vorstehender Kodierstift KS mit beispielhaft rechteckförmigem Querschnitt eingesetzt, welcher in die rechte Hälfte der Komplementärkammer K21 eingreift. Dementsprechend ist die nicht benötigte linke Hälfte der Komplementärkammer K21 in der Längsführungsschiene UFS mit einem Komplementärkodierstift KSP verschlossen. Eine Veränderung der Kodierung kann auf einfache Weise durch Drehung des Kodierstiftes KS und des Komplementärkodierstiftes KSP um jeweils 90 ° bewirkt werden. In den Figuren 1,2 sind die anderen Kodierkammern K12,K13 und die dazugehörigen Komplementärkammern K22,K23 aus Gründen der Übersichtlichkeit nicht mit Kodier- und Komplementärkodierstiften besetzt. Weist der Baugruppenträger BT eine sehr große Anzahl einzuschiebender Flachbaugruppen auf, so können diese Kammern selbstverständlich zur Erhöhung der Kodiervariationen in entsprechender Weise mit weiteren Kodier- und Komplementärkodierstiften bestückt werden, bzw. es können auch mehr Kammern vorgesehen sein.

Gemäß einer weiteren, in FIG 2 bereits dargestellten Ausführungsform greifen die Führungsstifte ZS1,ZS2 des Eckmontagekörpers UM beim Einschubvorgang in zusätzliche, in den Seitenflanken FS am frontseitigen Ende der Längsführungsschiene UFS befindliche Nuten SN1,SN2 ein. Derartige Nuten haben den Vorteil, daß die Flachbaugruppe beim Einschieben nicht nur in Querrichtung, sondern auch in vertikaler Richtung geführt wird. Es ist somit kein Ausweichen derselben beim Einschieben in den Baugruppenträger in irgend einer Raumrichtung mehr möglich.

FIG 2 zeigt schließlich als einen weiteren, möglichen Bestandteil des Baugruppenträgers BT ausschnittsweise eine untere Querverbindungsschiene UVS, auf der das frontseitige Ende der unteren Längsführungsschiene UFS fest verankert ist. In entsprechender Weise kann eine weitere, obere Querverbindungsschiene OVS vorhanden sein, die als Träger der dazugehörigen Längsführungsschiene OFS dient. Im Beispiel der Figuren 1,2 weist die Querverbindungsschiene UVS am frontseitigen Ende des Baugruppenträgers BT einen zusätzlichen, querverlaufenden Aufnahmeschlitz auf. In diesen können Schraubverbindungen eingreifen, um die eingeschobenen Flachbaugruppen im eingesteckten Zustand zu fixieren. Hierzu kann z.B. gemäß FIG 1 eine Schraube durch eine untere Montagebohrung MBU in einer unteren Montagelasche MLU des unteren Eckmontagekörpers UM hindurchgreifen und in geeigneten, im Aufnahmeschlitz AS befindlichen Haltemitteln fixiert werden.

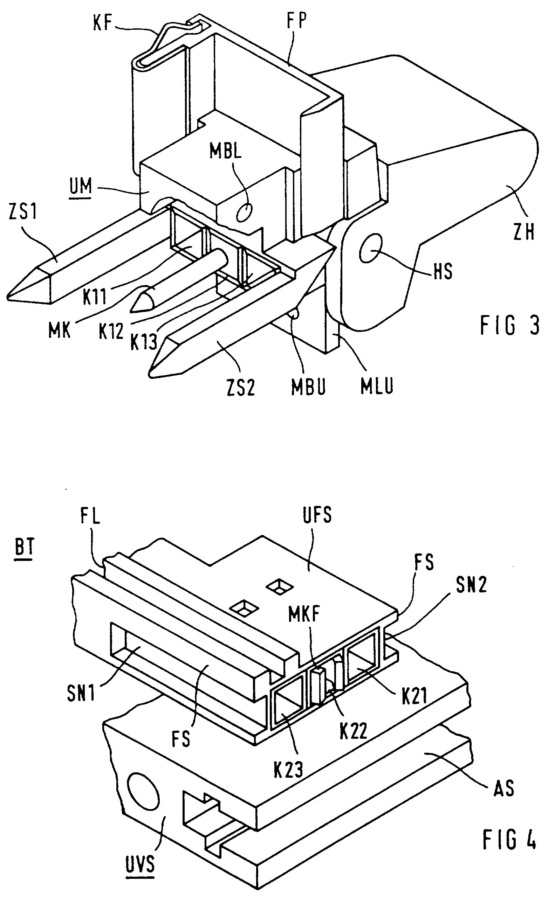

In den Figuren 3,4 ist eine weitere vorteilhafte Ausführungsform der Erfindung dargestellt. Dabei ist beispielhaft die mittlere Kodierkammer K12 der Einsteckkodiermittel des Eckmontagekörpers UM zwischen den Führungsstiften ZS1,ZS2 mit einem Massekontaktstift MK belegt. Dieser greift beim Einstecken der Flachbaugruppe in ein Kontaktmitteln ein, insbesondere eine Massekontaktfeder MKF, welche gemäß der Darstellung von FIG 4 in die gegenüberliegende Komplementärkammer K22 am frontseitigen Ende der Längsführungsschiene UFS eingesetzt ist. Auch in diesem Fall bewirkt die erfindungsgemäße voreilende Abstützung der Führungsstifte ZS1,ZS2 des Eckmontagekörpers UM an den Seitenflanken FS der gegenüberliegenden Längsführungsschiene UFS, daß beim Einschubvorgang der Flachbaugruppe der Massekontaktstift MK positionsgenau und exakt zentriert auf die Massekontaktfeder MKF zugeführt wird. Eine versehentliche Beschädigung der Massekontaktfeder aufgrund eines ungenauen Auftreffens des Massekontaktstiftes MK wird somit vorteilhaft verhindert, da zumindest in der Endphase der Einschubbewegung kein Ausweichen des frontseitigen Endes der Flachbaugruppe in Querrichtung und bei Vorhandensein der Nuten SN1,SN2 auch in vertikaler Richtung mehr möglich ist.

FIG 5 zeigt schließlich das frontseitige Ende einer die Leiterplatte LP aufweisenden Flachbaugruppe im vollständig in den Baugruppenträger BT eingesteckten Zustand. Dieser weist zumindest eine untere und eine obere Längsführungsschiene UFS,OFS auf, in deren Führungsnuten FL die untere und obere Längskante der Leiterplatte gehalten wird. Der Baugruppenträger weist vorteilhaft zusätzlich eine untere und obere Querverbindungsschiene UVS,OVS auf, auf deren Innenseiten die frontseitigen Enden der Längsführungsschienen UFS,OFS fest angebracht sind. Die Flachbaugruppe weist im dargestellten Fall einen unteren und einen oberen Eckmontagekörper UM,OM auf, welche an den beiden frontseitigen Ecken der Leiterplatte LP befestigt sind. Die erfindungsgemäßen sichtbaren Führungsstifte ZS2 an den Außenseiten dieser Eckmontagekörper stützen sich dabei in Führungsnuten SN1 in der linken Seitenflanke FS der oberen und unteren Längsführungsschiene UFS,OFS ab. Die Eckmontagekörper UM,OM dienen zudem als Träger von je einem Ziehhebel ZH. Als frontseitiger Abschluß der Flachbaugruppe ist schließlich ein Frontsteckverbinder FSV vorgesehen.

## Patentansprüche

1. Flachbaugruppe mit Leiterplatte (LP) zum Einschub in einen Baugruppenträger (BT), welcher zumindest eine untere und eine obere Längsführungsschiene (UFS,OFS) mit jeweils einer Führungsnut (FL) für die Längskanten der Leiterplatte (LP) beim Einschub bzw. Auszug der Flachbaugruppe in den bzw. aus dem Baugruppenträger (BT) aufweist,
**dadurch gekennzeichnet,** daß die Flachbaugruppe mindestens einen Eckmontagekörper (UM bzw.OM) aufweist, welcher an einer der beiden frontseitigen Ecken der Leiterplatte (LP) befestigt ist und an den beiden Außenseiten je einen Führungsstift (ZS1,ZS2) aufweist, und die Führungsstifte (ZS1,ZS2) annähernd parallel zu den Längskanten der Leiterplatte (LP) angeordnet sind, in Einschubrichtung der Leiterplatte (LP) auf den Baugruppenträger gerichtet hervorstehen und sich beim Einschieben der Flachbaugruppe (BT) auf den Seitenflanken (FS) der jeweils gegenüberliegenden Längsführungsschiene (UFS bzw. OFS) des Baugruppenträgers (BT) abstützen.

2. Flachbaugruppe nach Anspruch 1,
**dadurch gekennzeichnet,** daß die Führungsstifte (ZS1,ZS2) des mindestens einen Eckmontagekörpers (UM bzw.OM) in zusätzliche Nuten (SN1,SN2) in den Seitenflanken (FS) am frontseitigen Ende der Längsführungsschiene (UFS bzw.OFS) eingreifen.

3. Flachbaugruppe nach Anspruch 1 oder 2,
**dadurch gekennzeichnet,** daß der Eckmontagekörper (UM bzw.OM) im Bereich zwischen den beiden Führungsstiften (ZS1,ZS2) Einsteckkodiermittel (K11,K12, K13;KS) aufweist, welche beim Einstecken der Flachbaugruppe in den Baugruppenträger (BT) in Komplementärkodiermittel (K21,K22,K23;KSP) eingreifen, die sich am frontseitigen Ende der Längsführungsschiene (UFS bzw.OFS) befinden.

4. Flachbaugruppe nach Anspruch 3,
**dadurch gekennzeichnet**, daß die Einsteck- und Komplementärmittel jeweils gegenüberliegende Kammern (K11,K12,K13 und K21,K22,K23) im Eckmontagekörper (UM bzw. OM) und am frontseitigen Ende der Längsführungsschiene (UFS bzw. OFS) des Baugruppenträgers (BT) aufweisen, in die Kodier- und Komplementärkodierstifte (KS,KSP) einsetzbar sind (FIG 1,2).

5. Flachbaugruppe nach Anspruch 4,
**dadurch gekennzeichnet**, daß in zumindest eine der Kammern (K12) des Eckmontagekörpers (UM bzw. OM) zwischen den Führungsstiften (ZS1,ZS2) ein Massekontaktstift (MK) eingesetzt ist, welcher in mindestens ein Kontaktmittel eingreift, insbesondere eine Massekontaktfeder (MKF), die in der gegenüberliegenden Kammer (K22) am frontseitigen Ende der Längsführungsschiene (UFS bzw. OFS) eingesetzt ist (FIG 3,4).

6. Flachbaugruppe nach einem der vorangegangenen Ansprüche,
**dadurch gekennzeichnet,** daß der Eckmontagekörper (UM bzw. OM) zur Halterung weiterer Teile dient, insbesondere von einem Ziehhebel (ZH,HS) und einer Frontplatte (FP) bzw. eines Frontsteckers (FSV) (FIG 1,3,5).

## Claims

1. A printed circuit module having a circuit board (LP) for insertion into a mounting rack (BT) which has at least one lower and one upper longitudinal guide rail (UFS, OFS), each with a groove (FL) for guiding the longitudinal edges of the circuit board (LP) as the printed circuit module is pushed into or pulled out from the mounting rack (BT),
characterised in that
the printed circuit module has at least one corner mounting member (UM or OM) which is fixed to one of the two front corners of the circuit board (LP) and has on each of its two outer sides a respective guide pin (ZS1, ZS2), and that the guide pins (ZS1, ZS2) are disposed substantially parallel to the longitudinal sides of the circuit board (LP), project towards the mounting rack in the direction of insertion of the circuit board (LP), and on insertion of the module are supported on the side flanks (FS) of the respective facing longitudinal guide rail (UFS or OFS) of the mounting rack (BT).

2. A printed circuit module according to claim 1, characterised in that the guide pins (ZS1, ZS2) of the at least one corner mounting member (UM or OM) engage in additional grooves (SN1, SN2) in the side flanks (FS) at the front end of the longitudinal guide rails (UFS or OFS).

3. A printed circuit module according to claim 1 or claim 2, characterised in that the corner mounting member (UM or OM) has, in the region between the two guide pins (ZS1, ZS2), plug-in coding means (K11, K12, K13; KS) which on plugging the module into the mounting rack (BT) engage in complementary coding means (K21, K22, K23; KSP) which are located at the front end of the longitudinal guide rail (UFS or OFS).

4. A printed circuit module according to claim 3, characterised in that the plug-in and complementary coding means each have facing chambers (K11, K12, K13 and K21, K22, K23) in the corner mounting member (UM or OM) and at the front end of the longitudinal guide rail (UFS or OFS) of the mounting rack (BT) in which coding and complementary coding pins (KS, KSP) can be inserted (Figs. 1 and 2).

5. A printed circuit module according to claim 4, characterised in that in at least one of the chambers (K12) of the corner mounting member (UM or OM) a ground contact pin (MK) is inserted between the guide pins (ZS1, ZS2) which engages in at least one contact means, in particular a ground contact spring (MKF), which is inserted in the facing chamber (K22) at the front end of the longitudinal guide rail (UFS or OFS) (Figs. 3 and 4)

6. A printed circuit module according to one of the preceding claims, characterised in that the corner mounting member (UM or OM) serves to hold further parts, in particular a pulling lever (ZH, HS) and a front plate (FP) or front plug (FSV) (Figs. 1, 3, 5).

## Revendications

1. Module plat comportant une plaquette à circuits imprimés (LP) et destiné à être inséré dans un porte-module (BT), qui comporte au moins un rail de guidage longitudinal inférieur et un rail de guidage longitudinal supérieur (UFS,OFS) comportant chacun une rainure de guidage (FL) pour les bords longitudinaux de la plaquette à circuits imprimés (LP) lors de l'insertion ou du retrait du module plat dans ou hors du porte-module (BT), caractérisé par le fait que le module plat comporte au moins un corps de montage d'angle (UM ou OM), qui est fixé à l'un des deux coins avant de la plaquette à circuits imprimés (LP) et qui comporte, sur chacun des deux côtés extérieurs, une tige de guidage (ZS1,ZS2), les tiges de guidage (ZS1,ZS2) sont disposées approximativement parallèlement aux bords longitudinaux de la plaquette à circuits imprimés (LP), font saillie dans la direction d'insertion de la plaquette à circuits imprimés (LP) en direction du porte-modules et, lors de l'insertion du module plat (BT), prennent appui sur les flancs latéraux (FS) du rail de guidage longitudinal en vis-à-vis (UFS ou OFS) du porte-module (BT).

2. Module plat suivant la revendication 1, caractérisé par le fait que les tiges de guidage (ZS1,ZS2) d'au moins un corps de montage d'angle (UM ou OM) s'engagent dans des rainures supplémentaires (SN1,SN2) aménagées dans les flancs latéraux (FS) sur l'extrémité avant du rail de guidage longitudinal (UFS ou OFS).

3. Module plat suivant la revendication 1 ou 2, caractérisé par le fait que le corps de montage d'angle (UM ou OM) comporte, dans la zone située entre les deux tiges de guidage (ZS1,SZ2), des moyens de codage d'enfichage (K11, K12, K13;KS), qui, lors de l'enfichage du module plat dans le porte-module (BT), s'engagent dans des moyens de codage complémentaires (K21, K22, K23; KSP), qui sont situés sur l'extrémité avant du rail de guidage longitudinal (UFS ou OFS).

4. Module plat suivant la revendication 3, caractérisé par le fait que les moyens d'enfichage et les moyens complémentaires comportent chacun des chambres en vis-à-vis (K11,K12,K13 et K21,K22,K23), qui sont dans le corps de montage d'angle (UM ou OM) et sur l'extrémité avant du rail de guidage longitudinal (UFS ou OFS) du porte-module (BT) et dans lesquelles peuvent être insérées des tiges de codage et des tiges de codage complémentaires (KS,KSP) (figures 1, 2).

5. Module plat suivant la revendication 4, caractérisé par le fait que dans au moins l'une des chambres (K12) du corps de montage d'angle (UM ou OM) entre les tiges de guidage (ZS1,ZS2) est insérée une tige de contact de masse (MK), qui s'engage dans au moins un moyen de contact, notamment un ressort de contact de masse (MKF), qui est inséré dans la chambre en vis-à-vis (K22) aménagée dans l'extrémité avant du rail de guidage longitudinal (UFS ou OFS). (Figures 3, 4).

6. Module plat suivant l'une des revendications précédentes, caractérisé par le fait que le corps de montage d'angle (UM ou OM) sert à retenir d'autres pièces, notamment un levier de tirage (ZS,HS) et une plaque avant (FP) ou un connecteur frontal (FSV). (Figures 1, 3, 5).
